Europäisches Patentamt

European Patent Office

Office européen des brevets

(11) Publication number: **0 374 544**
**A1**

## EUROPEAN PATENT APPLICATION

(21) Application number: 89122082.4

(22) Date of filing: 30.11.89

(51) Int. Cl.[5]: **H01L 29/73, H01L 29/08**

(30) Priority: 06.12.88 JP 309083/88

(43) Date of publication of application:
**27.06.90 Bulletin 90/26**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Fujioka, Hiroshi**
**15-19-901 Nishikata 1-chome**
**Bunkyo-ku Tokyo, 113(JP)**

(74) Representative: **Schmidt-Evers, Jürgen,**
**Dipl.-Ing. et al**
**Patentanwälte Mitscherlich, Gunschmann**
**Dr. Körber, Schmidt-Evers, Melzer, Dr. Schulz**
**Steinsdorfstrasse 10**
**D-8000 München 22(DE)**

(54) A hetero bipolar transistor and a fabricating method thereof.

(57) A hetero bipolar transistor including an emitter layer (15), having a wide energy gap, made of an arsenic doped hydrogenated micro-crystal line silicon, having an average crystal grain size of 3.5 to 5.5 nm, formed on a p-type base layer (14) by applying a plasma CVD method, using a mixed gas of silane, hydrogen and arsine, is obtained so as to have common emitter current gain of 400.

EP 0 374 544 A1

FIG. 3 (h)

## A HETERO BIPOLAR TRANSISTOR AND A FABRICATING METHOD THEREOF

### BACKGROUND OF THE INVENTION

(1) field of The Invention

The present invention relates to an improvement of a Silicon Hetero Bipolar Transistor (Si HBT).

Usually, impurity concentration of a bipolar transistor must be controlled small to obtain large common emitter current gain ($h_{FE}$). However, in the bipolar transistor, when impurity concentration in a base is set small, base resistance becomes large, so that operation speed of the bipolar transistor decreases.

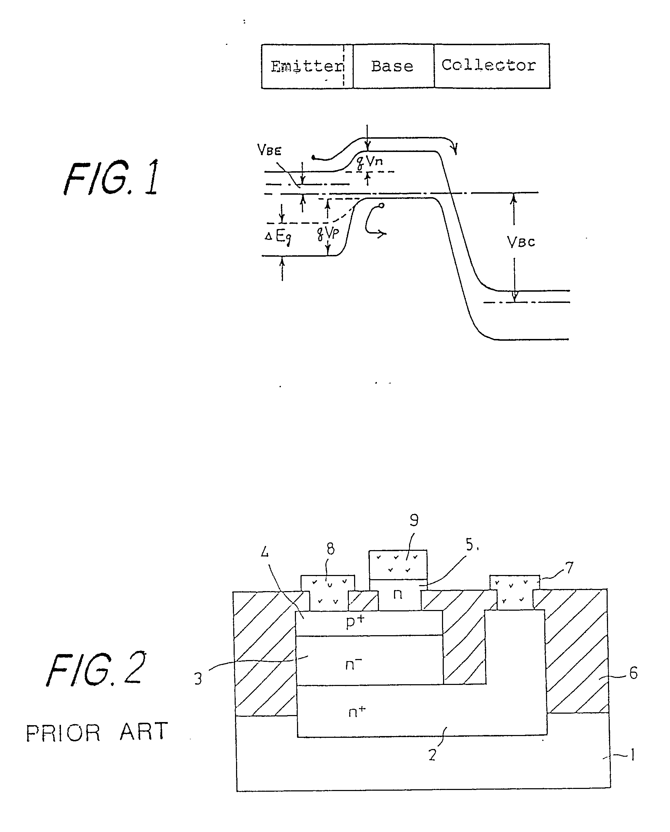

However, in case of a Hetero Bipolar Transistor (HBT), the impurity concentration is not necessary small to obtain the large $h_{FE}$, because, the HBT has hetero junction between a base and an emitter. As a result, in the HBT, a base layer can be made smaller in thickness, compared with that of the usual bipolar transistor. In other words, a large $h_{FE}$ can be obtained in HBT without increasing the base resistance. That is, the HBT is a transistor having structure excellent in high speed operation. The above features of the HBT are indicated by a diagram called an energy band diagram. As an example of the energy band diagram, Fig. 1 shows an energy band diagram of an npn type HBT.

As shown in Fig. 1, in the npn type HBT, an energy band gap of an emitter is larger than that of a base and a collector as much as $\Delta E_g$. Such energy band gap structure of the npn HBT is generally called "wide gap emitter structure". The npn type HBT operates under forward bias voltage $V_{BE}$ applied between the base and the emitter and reverse bias voltage $V_{BC}$ applied between the base and the collector. Therefore, a potential barrier $qV_n$ is produced in a conduction band and another potential barrier $qV_p$ is produced in a valence band, between the emitter and the base. The difference between $qV_p$ and $qV_n$ is namely the $\Delta E_g$ mentioned before. As a result, electrons (representatively indicated by a solid circle) in the emitter are injected into the base beyond the potential barrier $qV_n$, however, holes (indicated by a white circle) in the base are hard to be injected into the emitter beyond the potential barrier $qV_p$. In the usual npn bipolar transistor, this phenomenon does not occur. That is, holes in a base are easily injected into an emitter, because $qV_n$ is equal to $qV_p$. Thus, the npn HBT has the prominent feature that the holes injected from the base to the emitter are extremely suppressed, resulting in producing large $h_{FE}$.

(2) Description of The Prior Art

As an HBT having the wide gap emitter structure, a compound semiconductor HBT having hetero junction of aluminum gallium arsenide (AlGaAs) and gallium arsenide (GaAs) was initially developed. In the compound semiconductor HBT, an emitter was formed by AlGaAs having a large band gap and a base and a collector were formed by GaAs having a small band gap.

On the other hand, a new type HBT substantially using silicon material has been developed. This new type HBT will be called a "silicon group HBT" hereinafter. In the silicon group HBT, an emitter is formed by silicon micro-crystals each including hydrogen, and a base and a collector are formed by silicon single crystal. The silicon micro-crystal including hydrogen is correctly called "hydrogenated micro-crystalline silicon" and will be described "$\mu$c-Si:H" hereinafter. The details of the new HBT using the $\mu$c-Si:H have been disclosed in Proceedings ED87-66 of the Institute of Electronics, Information and Communication Engineers (IEICE), Japan, by H. Fujioka, 1987 and FUJITSU Scientific and Technical Journal Vol. 24, No. 4, pp. 391 - 397, 1987, titled as "Characteristics of Si HBT with Hydrogenated Micro-crystalline Si Emitter" by H. Fujioka and K. Takasaki.

Fig. 2 illustrates a cross-sectional view of the silicon group HBT inserted in the proceedings of IEICE and the FUJITSU Scientific and Technical Journal. In the silicon group HBT shown in Fig. 2, an emitter, a collector, a base and other parts associated with them are formed as follows: an $n^-$ collector 3 is formed on a part of an $n^+$ collector contact 2 formed on a silicon substrate 1; a $p^+$ base 4 is formed on the $n^-$ collector 3; an n-type emitter 5 is made of $\mu$c-Si:H and formed on a part of the $p^+$ base 4; and a collector electrode 7, a base electrode 8 and an emitter electrode 9 are respectively formed on the collector contact 2, the base 4 and the emitter 5, insulated by an insulation layer 6 respectively. Wherein, the material $\mu$c-Si:H of the emitter 5 can be formed to a layer 5 with a parallel-plate type plasma Chemical Vapor Deposition (CVD) apparatus.

Since an energy gap of silicon is 1.12 eV as well known, and an energy gap of the phosphorus- (P) doped $\mu$c-Si:H is 1.81 eV, a diffusion current due to holes flowing from the base 4 to the emitter 5 is suppressed, so that large $h_{FE}$ can be obtained.

To fabricate the silicon group HBT, hydrogenated micro-crystalline silicon germanium ($\mu$c-SiGe:H), hydrogenated micro-crystalline silicon carbide ($\mu$c-SiC:H) or hydrogenated micro-crystalline

silicon nitride ($\mu$c-SiN:H) has been tried to use instead of $\mu$c-Si:H, for increasing the energy gap more if possible.

In Fig. 2, it is important that the emitter 5 has a large band gap and a low resistivity for increasing the $h_{FE}$ of the silicon group HBT. In order to obtain a large band gap of the emitter 5, a grain size of each micro-crystal in the emitter 5 is required to be approximately less than 5 nm in diameter, and in order to lowering the resistiveity of the emitter 5, it is required to dope a large quantity of n-type impurity such as phosphorus into the emitter 5. However, when phosphorus is highly doped into the emitter 5, the grain size of the micro-crystal can not be decreased to less than 5 nm. Accordingly, in the prior art, it has been hard to enlarge the band gap of the emitter 5.

SUMMARY OF THE INVENTION

Therefore, an object of the present invention is to obtain a silicon group HBT having large common emitter current gain, with high reproducibility.

The above object is accomplished by forming an emitter of the silicon group HBT so as to obtain wide gap emitter structure, using As doped hydrogenated micro-crystalline silicon (As doped $\mu$c-Si:H) having silicon micro-crystals each having a small grain size and low resistivity. The wide gap emitter structure is formed by a plasma CVD method, using a mixed gas of monosilane (SiH₄), hydrogen (H₂) and arsine (AsH₃), for instance. An average grain size of the As doped $\mu$c-Si:H is 3.5 to 5.0 nm. This average grain size is smaller than that (4.5 to 10 nm) of the usual P doped $\mu$c-Si:H. A band gap of an emitter layer made of the As doped $\mu$c-Si:H is 1.95 eV which is larger than the band gap (1.81 eV) of the usual P doped $\mu$c-Si:H. Applying the As doped $\mu$c-Si:H to an emitter layer, the $h_{FE}$ of the silicon group HBT can be raised up as high as 400, in stable.

BRIEF DESCRIPTION OF THE DRAWINGS

Fig. 1 is a diagram showing energy band structure of the npn HBT;

Fig. 2 is a schematic cross sectional view of the silicon group HBT;

Figs. 3(a) to 3(i) are diagrams illustrating the fabrication steps of the silicon group HBT including an emitter made of As doped $\mu$c-Si:H embodying the present invention;

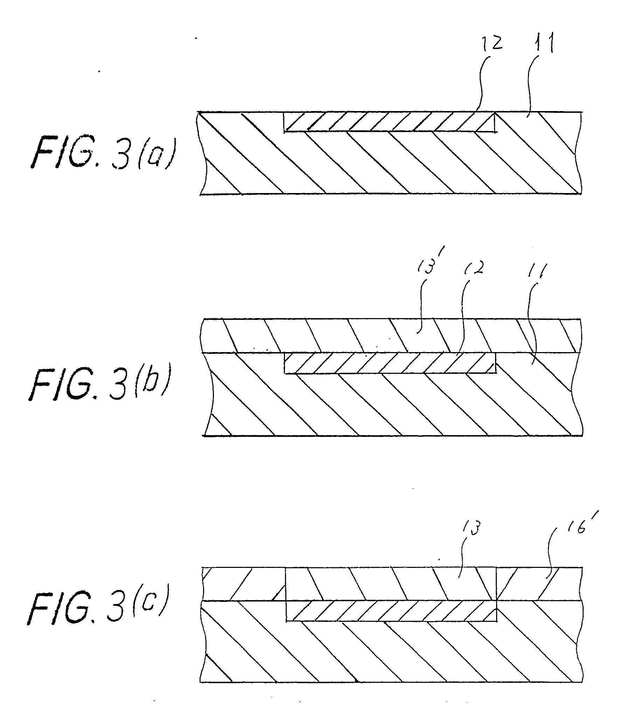

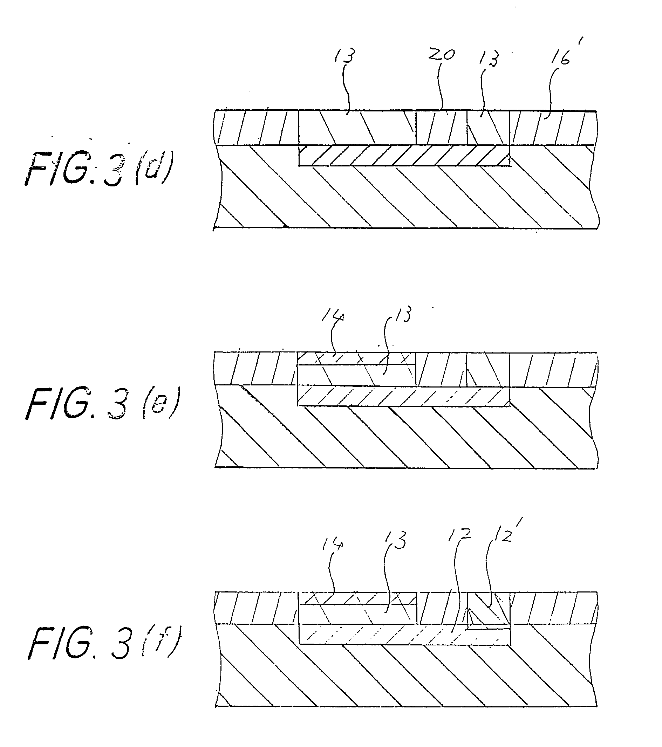

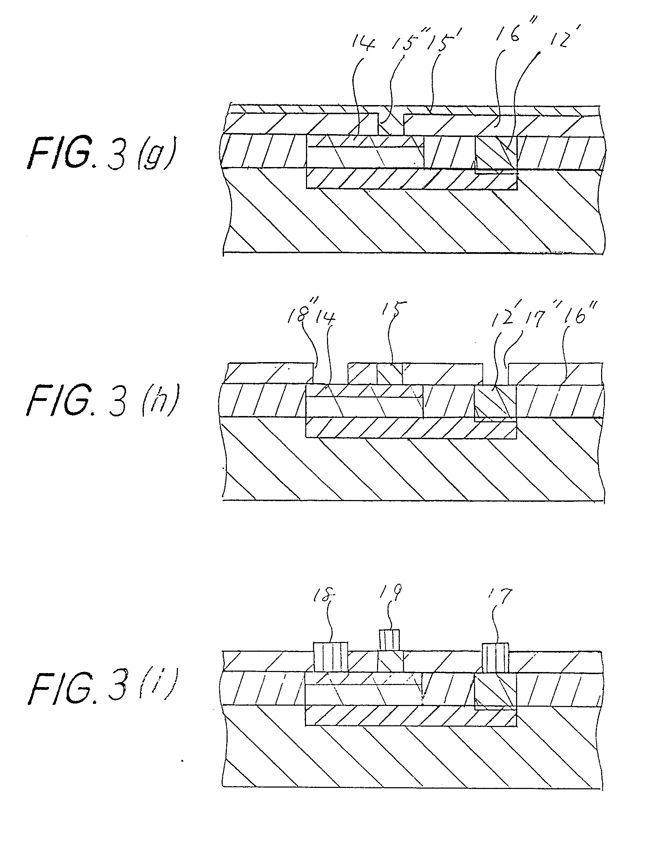

Fig. 3(a) is a diagram illustrating a step for forming an n⁺ collector layer on a part of a Si substrate;

Fig. 3(b) is a diagram illustrating a step for forming an n⁻ layer for the use of the collector by a vaporphase epitaxial method;

Fig. 3(c) is a diagram illustrating a step for forming an n⁻ collector layer by etching the n⁻ layer;

Fig. 3(d) is a diagram illustrating a step for forming an oxide layer in an aperture partly opened in the n⁻ collector layer;

Fig. 3(e) is a diagram illustrating a step for forming a base layer by performing selective ion implantation onto the n⁻ collector layer, using boron ions (B⁺);

Fig. 3(f) is a diagram illustrating a step for forming an n⁺ layer touched to an n⁺ collector-contact layer by performing selective ion implantation onto a part of the n⁻ collector layer, using antimony ions (Sb⁺);

Fig. 3(g) is a diagram illustrating a step for forming an $\mu$c-Si:H layer at an aperture opened in the base layer;

Fig. 3(h) is a diagram illustrating steps for forming a collector contact electrode, a base electrode and an emitter electrode on a collector ion injected layer, the base layer and the emitter layer respectively;

Fig. 3(i) is a diagram illustrating the formed $\mu$c-Si:H layer.

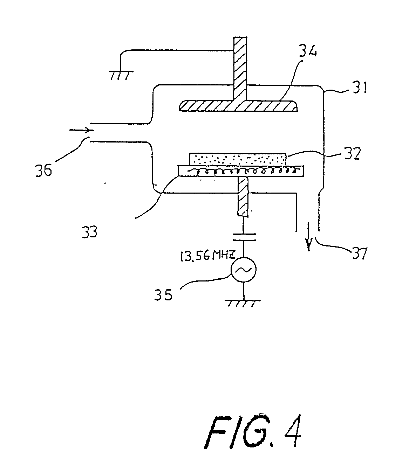

Fig. 4 is a partially cross sectional view schematically illustrating a parallel-plate type plasma CVD apparatus;

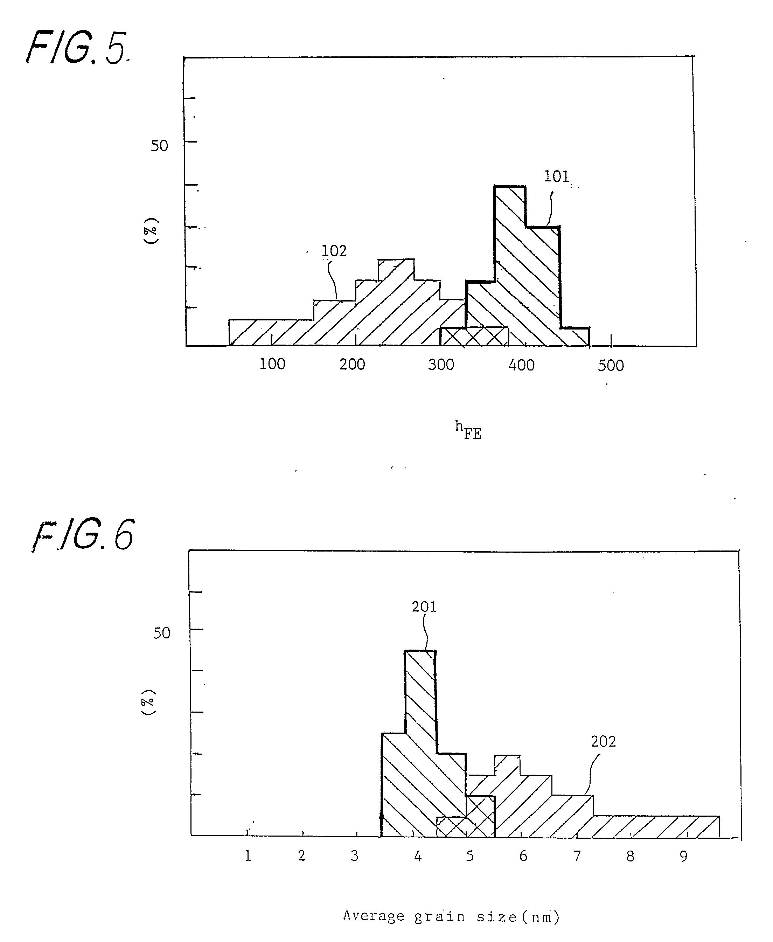

Fig. 5 is a chart showing an $h_{FE}$'s distribution regarding a plurality of the silicon group HBTs having emitters made of the As doped $\mu$c-Si:H and the p doped $\mu$c-Si:H; and

Fig. 6 is a chart showing a distribution of average grain sizes in the As doped and P doped $\mu$c-Si:H layers regarding a plurality of the silicon HBTs.

DESCRIPTION OF THE PREFERRED EMBODIMENTS

A fabricating method of a silicon group HBT of the present invention and characteristics thereof will be disclosed in reference to Figs. 3 to 6.

Figs. 3(a) to 3(i) are partial cross sectional views for explaining steps for fabricating the invented silicon group HBT having an emitter being an As doped $\mu$c-Si:H layer. The fabricating process of the present invention is almost the same with conventional one for a silicon bipolar transistor except a fabricating step of the As doped $\mu$c-Si:H layer.

The invented silicon group HBT is fabricated as follows:
an n⁺ collector contact layer 12 is formed on a designated portion of a p-type Si substrate 11 by ion implantation, using antimony ions (Sb⁺) or arsenic ions (As$^+$) (see Fig. 3(a));

an n$^-$ collector layer 13$'$ is formed on the p-type Si substrate 11 and the n$^+$ collector contact layer 12 by a vapor phase epitaxial method (see Fig. 3(b));

the n$^-$ collector layer 13$'$ is removed by etching, leaving an island shape n$^-$ collector 13 from the n$^-$ collector layer 13$'$ so that the n$^-$ collector 13 touches the n$^+$ collector contact layer 12, and an insulating film 16$'$ consisting of, for example, silicon dioxide (SiO$_2$) is deposited on the portion where the n$^-$ collector layer 13$'$ has been removed (see Fig. 3(c));

an oxide film 20 is formed in a part of the n$^-$ collector layer 13, by local oxidation process (see Fig. 3(d));

a base layer 14 is formed in a part of the n$^-$ collector layer 13 by implanting boron ions (B$^+$) into the part under energy of 20 Kev and dose of 5x10$^{13}$ cm$^{-2}$, applying selective ion implantation technique (see Fig. 3(e));

an ion-implanted collector layer 12$'$ is formed to another part of the n$^-$ collector 13 so as to touch the n$^+$ collector contact layer 12, by performing selective ion implantation into the part of the n$^-$ collector 13, using Sb$^+$, so that the n$^+$ collector contact layer 12 is extended to the level of surface of the base layer 14 (see Fig. 3(f));

a SiO$_2$ film 16$''$ is coated on the surface shown in Fig. 3(f) and an aperture 15$''$ (approximately 5x5 mm$^2$ in size) for an emitter is provided in the SiO$_2$ film 16$''$ until a part of the surface of the base layer 14 appears in the aperture 15$''$, and the surface in the aperture 15$''$ and on the SiO$_2$ film 16$''$ are cleaned with hydrogen fluoride solution, then, after cleaning, imediately, an As doped is formed in the cleaned aperture 15$''$ and on the cleaned surface of the SiO$_2$ film 16$''$ by using a conventional parallel-plate type plasma CVD apparatus shown in Fig. 4 (see Fig. 3(g)), wherein the formation of the As doped μc-Si:H layer 15$'$ will be detailed latter;

the As doped μc-Si:H film is removed by etching, leaving the As doped μc-Si:H stayed in the aperture 15$''$, and two apertures 17$'$ and 18$'$ are provided in the SiO$_2$ layer 16$'$ in correspondent to a part of the ion-implanted collector layer 12$'$ and a part of the base layer 14 respectively (see Fig. 3-(h)); and

a collector contact electrode 17, a base electrode 18 and an emitter electrode 19 are formed in the apertures 17$''$ and 18$''$ and on a surface of emitter layer 15 respectively, so that a silicon group HBT having an emitter of an μc-Si:H HBT layer is obtained (see Fig. 3(i)).

As mentioned before, the emitter of the As doped μc-Si:H HBT layer is formed by using the conventional parallel-plate type plasma CVD apparatus. Before disclosing how to form the emitter, the function of the parallel-plate type plasma CVD apparatus will be explained in reference to Fig. 4. In the parallel-plate type plasma CVD apparatus, a reactant gas used for plasma CVD is filled in a chamber 31 at a constant pressure, making flow the reactant gas into and out from the chamber 31 through a gas inlet 36 and a gas exhaust 37 respectively. In the chamber 31, there are an electrode 33 and an electrode 34 placed opposite to the electrode 34. A sample substrate 32 to be performed the plasma CVD is mounted on the electrode 33 and heated at a required temperature by a heater provided in the electrode 33. High frequency power at, for example, 13.56 MHz is applied between the electrodes 33 and 34 from a high frequency power source 35, so that the reactive gas is decomposed to a plasma gas. Then, in accordance with the plasma gas, a CVD film is formed on a surface of the substrate 32. At this time, the CVD film is avoided becomming porous by heating the sample substrate 32 at a proper temperature.

Using the parallel-plate type plasma CVD apparatus mentioned above, the As soped μc-Si:H is formed as follows: a mixed gas of silane (SiH$_4$), hydrogen (H$_2$) and arsine (AsH$_3$) is used as a reactant gas; at this time, a flow rate of the hydrogen is 10 times or more of a flow rate of the silane, and a flow rate of the arsine is 0.1 to 5% of a flow rate of the silane, when a flow rate of the silane is taken as 1, as an example, a gas mixing 50 SCCM of SiH$_4$, 1000 SCCM of H$_2$ and 0.5 SCCM of AsH$_3$ is used as the reactant gas; the pressure of the reactant gas in the reactant chamber 31 is desired to be higher than 0.02 Torr, and is kept at, for example, 0.2 Torr; the temperature of the sample substrate is desired to be between 200 and 400°C, and is kept at 250°C as an example; and the supplied high frequency power is 0.3 W cm$^2$.

Under such growth condition, the μc-Si:H film 15$'$ (see Fig. 3(g)) is formed. The concentration of As doped in the μc-Si:H film 15$'$ is desired to be high, for instance, 1x10$^{+3}$ cm$^{-3}$ in order to decrease the resistance of the emitter.

In accordance with forming thus the emitter layer 15 by using the As doped μc-Si:H, the grain sizes of the μc-Si:H in the emitter layer 15 can be made smaller than that in the case of using P doped μc-Si:H. As a result, the h$_{FE}$ of the Si group HBT having the emitter of the As doped μc-Si:H can be made greater than that of the P doped μc-Si:H. To compare the h$_{FE}$ of the Si group HBT having the emitter layer made of the As doped μc-Si:H with that having the emmiter layer made of the P doped μc-Si:H, a plurality of Si group HBTs respectively using the As doped μc-Si:H and the P doped μc-Si:H were fabricated and their h$_{FE}$s were measured. The results of the measurement are shown by a histogram in Fig. 5. In Fig. 5, the numbers of the two kinds of Si group HBTs correspondent to various $h_{FE}$s are presented in a percentage to the total number of the measured HBTs, on the axis of ordinates. In Fig. 5, a part 102 having slanting lines depicted downward from right to left shows the percentages for the Si group HBTs having the emitter layers made of the P doped $\mu c$-Si:H and a part 101 having slanting lines depicted downward from left to right shows the percentages for the Si group HBTs having the emitter layers made of the As doped $\mu c$-Si:H. As seen from Fig. 5, a value of $h_{FE}$ approximately positioning at the center of the part 101 concerning the As doped $\mu c$-Si:H is 400, however, the part 102 concerning the P doped $\mu c$-Si:H is distributed widely from less than 100 to approximate 400.

A plurality of P doped $\mu c$-Si:H films and of As doped $\mu c$-Si:H films were formed on a Si substrate, and grain sizes of micro-crystals in these films were measured with an X-ray diffraction method. The results of the measurement are shown by a histogram in Fig. 6, using average grain sizes. In Fig. 6, the numbers of the two kinds of $\mu c$-Si:H films correspondent to various average grain sizes are shown in a percentage to the total number of the measured $\mu c$-Si:H films, on the axis of ordinates. A part 201 having slanting lines depicted downward from left to right shows the percentages for the average grain sizes of the As doped $\mu c$-Si:H films and a part 202 having slanting lines depicted downward from right to left shows the percentages for the average grain sizes of the P doped $\mu c$-Si:H films. As seen from the parts 201 and 202, the average grain sizes (in the part 202) of the micro-crystals in the P doped $\mu c$-Si:H films are distributed in a range of approximate 4.5 to 9.5 nm, however, those (in the part 201) in the As doped $\mu c$-Si:H films are distributed in a range of approximately 3.5 to 5.5 nm which is narrower in range and small in value, compared with the case of the P doped $\mu c$-Si:H films. On the other hand, energy gap of the P doped $\mu c$-Si:H films and the As doped $\mu c$-Si:H films were measured by optical spectoroscopy. The results were 1.81 eV for the P doped $\mu c$-Si:H films and 1.95 eV for the As doped $\mu c$-Si:H films.

Furthermore, crystal structure of the As doped $\mu c$-Si:H film and the P doped $\mu c$-Si:H film, which were formed 50 nm in thickness on silicon substrates, were observed with Reflective High Energy Electron Diffraction (RHEED) method. As a result, it could be seen that the P doped $\mu c$-Si:H film happened to be grown epitaxially in some growth condition, however, the As doped $\mu c$-Si:H film included only micro-crystals in any growth condition. From this fact, it can be concluded that the silicon group HBT having the emitter made of the As doped $\mu c$-Si:H has more stable $h_{FE}$, compared with the silicon group HBT having the emitter made of the P doped $\mu c$-Si:H.

In the above, the material of $\mu c$-Si:H is used to the emitter layer of the silicon group HBT. However, instead of $\mu c$-Si:H, a material of hydrogenated micro-crystalline silicon carbide ($\mu c$-SiC:H), hydrogenated micro-crystalline silicon nitride ($\mu c$-SiN:H) or hydrogenated micro-crystalline silicon germanium ($\mu c$-SiGe:H) can be used.

## Claims

1. A hetero bipolar transistor comprising:
a collector region (12, 12');
a base region (14) touched to said collector region (12, 12'); and
an emitter region (15) forming hetero junction with said base region (14) and made of hydrogenated silicon group material including arsenic (As).

2. A hetero bipolar transistor according to claim 1, wherein said hydrogenated silicon group material comprising a material selected from the group of consisting of hydrogenated microcrystalline silicon ($\mu c$-Si:H) material, hydrogenated microcrystalline silicon carbide ($\mu c$-SiC:H) material, hydrogenated micro-crystalline silicon nitride ($\mu c$-SiN:H) material and hydrogenated micro-crystalline silicon germanium ($\mu c$-SiGe:H) material.

3. A hetero bipolar transistor according to claim 1 or 2, wherein said emitter region comprises hydrogenated microcrystalline silicon ($\mu c$-Si:H) material having crystal grain sizes being less than 6 nm.

4. A hetero bipolar transistor according to any of claims 1 to 3, said base region (14) comprises a material of p-type silicon, and said collector (12, 12') region comprises a material of n-type silicon.

5. A hetero bipolar transistor according to any of claims 1 to 4, said emitter region (15) has an energy gap more than 1.9 eV.

6. A method for fabricating a hetero bipolar transistor including a collector (12, 12') and a base (14) which are made of silicon and an emitter (15) made of hydrogenated silicon group material and making hetero junction with said base (14), said method comprising the steps of:
forming a collector layer (12) made of n-type silicon;
forming a base layer (14) made of p-type silicon so as to touch said collector layer (12); and
forming an emitter layer (15) made of hydrogenated microcrystalline silicon including arsenic (As) on said base layer (14), by supplying As in a reactant gas on the surface of said base layer (14).

7. A method according to claim 6, wherein said emitter layer (15) is grown by applying a plasma chemical vapor deposition (plasma CVD) method.

8. A method according to claim 6, wherein said As reactant gas comprises silane, hydrogen and arsine, in a flow ratio of 1 to more than 10 to a value between 0.1 and 0.5, respectively.

9. A method according to claim 7, wherein said plasma CVD method is carried out by setting a substrate temperature at 200 to 400°C.

FIG. 1

| Emitter | Base | Collector |

FIG. 2

PRIOR ART

FIG. 3(a)

FIG. 3(b)

FIG. 3(c)

FIG. 3 (d)

FIG. 3 (e)

FIG. 3 (f)

FIG. 3 (g)

FIG. 3 (h)

FIG. 3 (i)

*FIG.* 4

## FIG.5

$h_{FE}$

## FIG.6

Average grain size (nm)

European Patent Office

# EUROPEAN SEARCH REPORT

Application Number

EP 89 12 2082

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN, vol. 13, no. 99 (E-724)[3447], 8th March 1989; & JP-A-63 274 175 (NTT) 11-11-1988 * Abstract * | 1,2,4,6 | H 01 L 29/73 H 01 L 29/08 |
| A | INTERNATIONAL ELECTRON DEVICES MEETING, San Francisco, 9th - 12th December 1984, pages 746-748, IEEE, New York, US; M. GHANNAM et al.: "A silicon biloar transistor with a hydrogenated amorphous emitter" * Page 1, column 2, lines 9-24 * | 1,6,7,9 | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 03-04-1990 | NILES N.P.E. |